Europäisches Patentamt

European Patent Office

Office européen des brevets

(11) Veröffentlichungsnummer: **0 040 817**
**A1**

## (12) EUROPÄISCHE PATENTANMELDUNG

(21) Anmeldenummer: 81103895.9

(22) Anmeldetag: 20.05.81

(51) Int. Cl.³: **H 01 L 29/747,** H 01 L 23/56,
H 01 L 31/10

(30) Priorität: **23.05.80 DE 3019907**

(43) Veröffentlichungstag der Anmeldung: **02.12.81**
**Patentblatt 81/48**

(84) Benannte Vertragsstaaten: **CH DE FR GB IT LI SE**

(71) Anmelder: **SIEMENS AKTIENGESELLSCHAFT Berlin
und München, Postfach 22 02 61,
D-8000 München 22 (DE)**

(72) Erfinder: **Tihanyi, Jenö, Dr., Ing. Dipl.-Phys.,
Wolfratshauser Strasse 179 b, D-8000 München 71 (DE)**

(54) **Lichtsteuerbarer Zweirichtungsthyristor.**

(57) Herkömmliche lichtsteuerbare Zweirichtungsthyristoren (Triacs) benötigen zum sicheren und schnellen Ansteuern relativ hohe Lichteinstrahlung. Die Steuerleistung läßt
sich drastisch vermindern, wenn als opto-elektrischer
Wandler für jeden Teilthyristor (5, 4, 3, 2; 8, 4, 7, 6) ein
Fototransitor (10, 14) verwendet wird, dessen Ausgangsspannung einen FET (9, 13) leitend steuert. Die Laststrecke
des FET (9, 13) überbrückt den sperrenden pn-Übergang
des in Kipprichtung vorgespannten Teilthyristors und schaltet diesen sehr rasch ein. Die Erfindung ist zum Beispiel für
Schalter mit Potentialtrennung in Hausgeräten anwendbar.

SIEMENS AKTIENGESELLSCHAFT
Berlin und München

Unser Zeichen
VPA

80 P 1073 E

0040817

## Lichtsteuerbarer Zweirichtungsthyristor

Die Erfindung bezieht sich auf einen lichtsteuerbaren Zweirichtungsthyristor mit zwei in einen Halbleiterkörper integrierten, antiparallel geschalteten Teilthyristoren, die jeweils eine katodenseitige Emitterzone, eine katodenseitige Basiszone, eine anodenseitige Emitterzone und eine anodenseitige Basiszone aufweisen, und mit einem in den Halbleiterkörper integrierten elektro-optischen Wandler.

Solche lichtsteuerbaren Zweirichtungsthyristoren sind bereits beschrieben worden und werden im technischen Sprachgebrauch als "Triac" bezeichnet. Der elektro-optische Wandler wird meistens durch zwei Zonen des Halbleiterkörpers gebildet, von denen eine bei Lichteinfall Ladungsträger emittiert, die in Richtung des in Kipprichtung vorgespannten pn-Übergangs fließen. Dann wird je nach Richtung der an den Triac angelegten Spannung entweder der eine oder der andere Teilthyristor leitend gesteuert.

Das Hauptproblem bei einem lichtsteuerbaren Triac besteht darin, diesen schnell und sicher zu zünden. Dazu bedarf es im allgemeinen eines starken Lichteinfalls, das heißt einer hohen Ansteuerleistung.

Der Erfindung liegt die Aufgabe zugrunde, einen lichtsteuerbaren Triac der eingangs erwähnten Art so weiterzubilden, daß er auch mit geringen Lichtleistungen schnell, das heißt mit geringer Einschaltverzögerung, eingeschaltet werden kann.

Hab 1 Dx / 19.05.1980

0040817

Die Erfindung ist dadurch gekennzeichnet, daß die katodenseitige Emitterzone oder Basiszone jedes Teilthyristors mit der anodenseitigen Basiszone jeweils über die Laststrecke eines Feldeffekttransistors (FET) verbunden ist, derart, daß die Quelle des FET an der katodenseitigen Emitterzone oder Basiszone angeschlossen ist, daß für jeden FET ein opto-elektrischer Wandler vorgesehen ist, dessen Ausgang mit dem Steuereingang des FET verbunden ist.

Unter "Laststrecke" wird dabei die Strecke Quelle (Source)-Kanal-Senke (Drain) verstanden.

Weiterbildungen der Erfindung sind Gegenstand der Unteransprüche.

Die Erfindung wird an Hand eines Ausführungsbeisiels in Verbindung mit den Fig. 1 bis 5 näher erläutert. Es zeigen:

Fig. 1 und 2 eine schematische Darstellung der Erfindung in zwei verschiedenen Betriebszuständen,

Fig. 3 eine Aufsicht auf einen Triac gemäß der Erfindung in lateraler Ausführung,

Fig. 4 einen Schnitt durch die Anordnung nach Fig. 3 entlang der Linie IV-IV und

Fig. 5 einen Schnitt durch die Anordnung nach Fig. 3 entlang der Linie V-V.

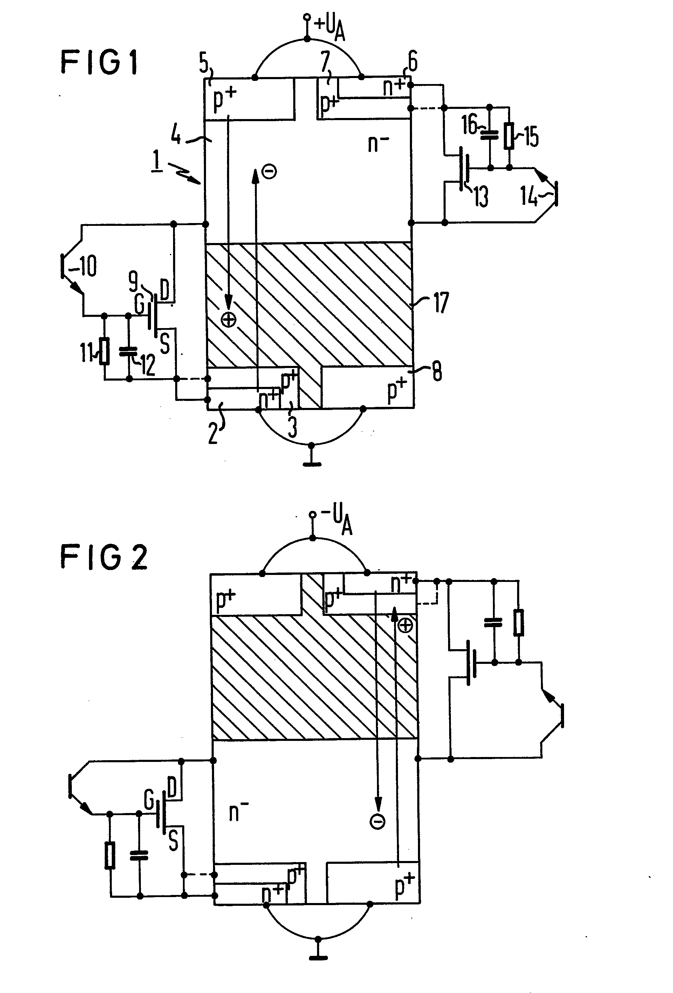

In Fig. 1 ist schematisch der Schnitt durch einen Halbleiterkörper 1 eines Triac dargestellt. Er besteht aus zwei antiparallel geschalteten, in den Halbleiterkörper integrierten Teilthyristoren. Der erste Teilthyristor auf der linken Seite hat eine katodenseitige Emitterzone 2, eine katodenseitige Basiszone 3, eine anodenseitige Basiszone 4 und eine anodenseitige Emitterzone 5. Die entsprechenden Zonen des antiparallel geschalteten Teil-

0040817
80 P 1073 E

thyristors auf der rechten Seite sind 6, 7, 4, 8. Die katodenseitigen Emitterzonen 2, 6 der Teilthyristoren sind mit der beiden Teilthyristoren gemeinsamen anodenseitigen Basiszone 4 über die Laststrecke eines FET 9 beziehungsweise 13 verbunden. Alternativ können auch die katodenseitigen Basiszonen 3, 7 über die Laststrecken der FET mit der Zone 4 verbunden sein. Die FET tragen die Anschlußbezeichnungen G für Steueranschluß (Gate), S für Quelle (Source) und D für Senke (Drain). Zwischen der Senke D der FET und deren Steueranschlüssen liegt der Ausgang je eines opto-elektrischen Wandlers 10 beziehungsweise 14. Im vorliegenden Fall sind dies Fototransistoren. Bei ausreichendem Lichtangebot können auch Fotodioden oder Fotoelemente verwendet werden. Zwischen dem Steueranschluß G und der Quelle S liegt jeweils eine Parallelschaltung bestehend aus einem Widerstand 11 und einem Kondensator 12 beziehungsweise einem Widerstand 15 und einem Kondensator 16. Die Zonen 5 und 6 sowie die Zonen 2 und 8 des Triacs sind elektrisch miteinander verbunden.

Bei der eingezeichneten Polarität der Spannung $U_A$ baut sich in der Zone 4 eine Raumladungszone 17 auf, die schraffiert dargestellt ist. Dabei ist der linke Teilthyristor in Kipprichtung vorgespannt, das heißt der pn-Übergang zwischen den Zonen 3 und 4 ist gesperrt. Fällt nun Licht auf die Fototransistoren 10, 14, so wirkt sich das für den rechten Teilthyristor nicht aus, da der pn-Übergang zwischen den Zonen 7 und 4 bereits in Durchlaßrichtung vorgespannt ist. Es kann daher alleine der linke Teilthyristor betrachtet werden. Beim Lichteinfall wird der Fototransistor 10 leitend. Sein Laststrom fließt von der Zone 4 über den Widerstand 11 in die Zone 3. Am Widerstand 11 wird eine Spannung erzeugt, die den Steuereingang G des FET 9 gegenüber der Quelle S positiv vorspannt. Bei Überschreiten der Einsatzspannung wird der FET leitend und negative Ladungsträger aus der katodenseitigen Emitterzone 2 fließen über die Laststrecke des FET unter Umgehung des gesperrten pn-Übergangs zwischen den Zonen 3 und 4 direkt in die Basiszone 4. Dies hat eine Emission von positiven Ladungsträgern aus der anodenseitigen Emitterzone 5 zur Folge, die durch die Zone 4 in Richtung auf die Zone 3 diffundieren. Durch die Wirkung des eingeschalteten FET werden weiter negative Ladungsträger aus der Zone 2 emittiert und fließen über den FET in die Zone 4, bis der pn-Übergang zwischen den Zonen 3 und 4 in Flußrichtung vorgespannt ist. Dann kann der linke Teilthyristor des Triacs zünden und der Laststrom beginnt zu fließen.

Mit der Spannung $-U_A$ am Triac ergeben sich entsprechende Verhältnisse für den rechten Teilthyristor. Diese sind in Fig. 2 dargestellt. Die Funktion ist analog der nach Fig. 1, so daß auf eine gesonderte Erläuterung verzichtet werden kann.

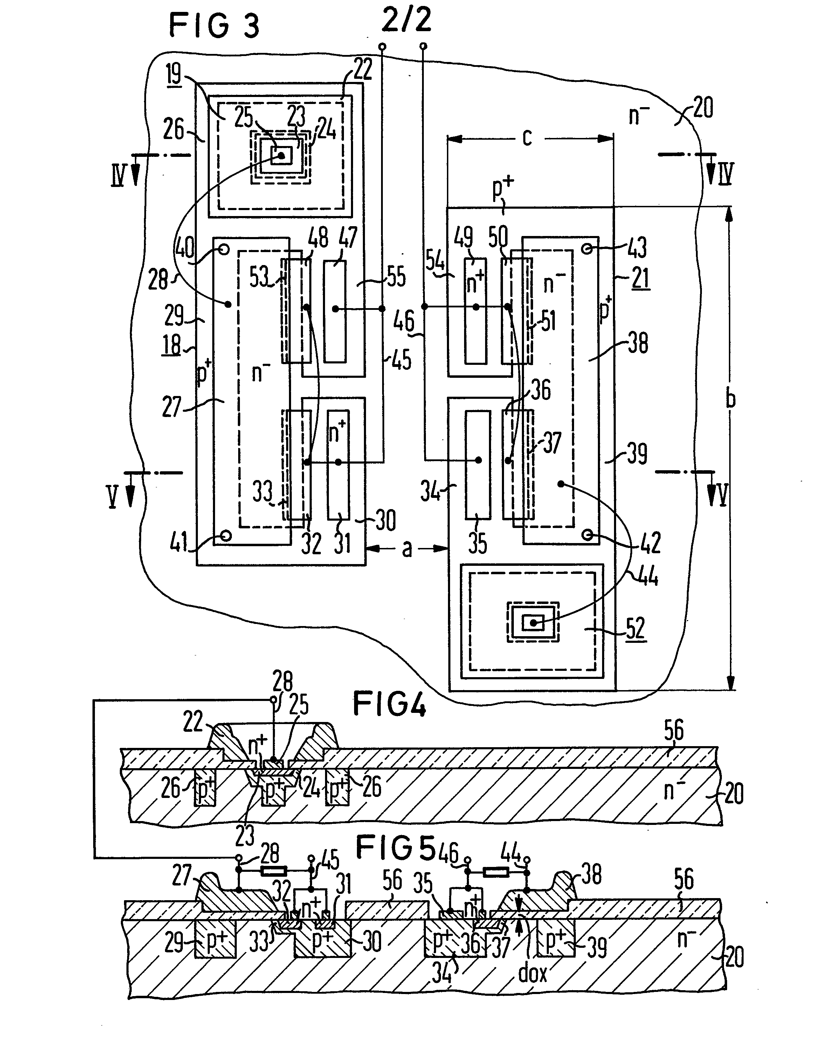

Eine funktionsfähige laterale Ausführungsform des lichtsteuerbaren Triacs ist in den Fig. 3, 4 und 5 dargestellt. Der Aufbau und die Wirkungsweise wird durch Bezugnahme auf alle drei Figuren erläutert.

Die beiden Teilthyristoren, die zugeordneten Fototransistoren mit ihren FET sind auf einem Substrat 20 angeordnet, das schwach n-leitend ausgebildet ist. In dieses Substrat 20 sind zwei stark p-leitende Bereiche 18 und 21 eingebettet. Innerhalb einer Aussparung des Bereichs 18 ist eine ebenfalls stark p-dotierte Zone 24 in das Substrat 20 eingebettet. In die Zone 24 ist eine Zone 23 des entgegengesetzten Leitungstyps eingelassen. Die Zone 23 bildet die Emitterzone eines der Fototransistoren, die Zone 24 dessen Basiszone und das Substrat 20 seine Kollektorzone. Die Emitterzone 23 ist mit einer Elektrode 25 kontaktiert, die klein und/oder dünn genug ist, um den Lichteinfall nicht zu behindern. Die Zonen 23, 24 sind von einer stark p-dotierten Zone 26 umgeben, die Teil des Bereichs 18 ist. Die Zone 26 dient dazu, ein Abfließen der durch den Lichteinfall erzeugten Träger zu anderen Strukturen des Triacs zu verhindern. Der Fotostrom kann daher nur zur Elektrode 25 in den Anschluß 28 abfließen. Der Rand des Fototransistors ist mit einer Schutzschicht 22, zum Beispiel aus Poly-Silicium, bedeckt.

Der erste Teilthyristor des Triacs weist eine katodenseitige, stark p-dotierte Basiszone 30 auf, die in das Substrat 20 eindiffundiert ist. In die Zone 30 sind stark n-dotierte Zonen 31 und 32 eingebettet, die beispielsweise durch Ionenimplantation hergestellt sein können. Die Zone 31 bildet die katodenseitige Emitterzone des ersten Teilthyristors, die Zone 32 bildet die Quelle des FET. Die Steuerzone 33 des FET ist durch einen Teil der katodenseitigen Basiszone 30 des ersten Teilthyristors gebildet. Sie ist ebenfalls durch Ionenimplantation hergestellt. Sie ist dünner als die Zone 30 und verläuft vorzugsweise schräg ansteigend zur Oberfläche des Substrats 20.

Die anodenseitige Emitterzone 34 des ersten Teilthyristors liegt im Bereich 21. Sie ist stark p-dotiert, hat gleiche Tiefe wie die Zone 30 und ist ebenfalls in das Substrat 20 eindiffundiert. Die Zone 34 ist mit einer Elektrode 35 kontaktiert, die mit einer Zuleitung 46 verbunden ist. In der Zone 34 kann noch eine stark n-dotierte Zone 36 liegen, die ebenfalls durch Ionenimplantation hergestellt ist. Die Zone 36 ist Teil der Quelle des dem zweiten Teilthyristor zugeordneten FET. Seine Steuerzone ist mit 37 bezeichnet.

Der zweite Teilthyristor enthält den Fototransistor 52, der gleich wie der Fototransistor 19 aufgebaut ist. Der zweite Teilthyristor ist nicht im Schnitt dargestellt, sein Aufbau entspricht dem Schnitt nach Fig. 5, liegt jedoch spiegelbildlich dazu. Er besteht aus der katodenseitigen Emitterzone 49, der Quelle 50 des zugeordneten FET mit der Steuerzone 51, wobei diese Zonen in die katodenseitige Basiszone 54 des zweiten Teilthyristors eingebettet sind. Seine anodenseitige Emitterzone ist mit 55 bezeichnet. Sie ist mit einem Kontakt 47 versehen. In der Zone 55 ist noch eine stark n-dotierte Zone 48 eingelagert, die Teil des dem ersten Teilthyristor zugeordneten FET ist.

Entsprechend dem Prinzipschaltbild nach den Fig. 1 und 2 ist die katodenseitige Emitterzone des einen Teilthyristors mit der anodenseitigen Emitterzone des anderen Teilthyristors elektrisch verbunden. Dies wird durch die Leitungen 45 und 46 symbolisiert. Diese Leitungen sind als diskrete Leiter gezeichnet, zweckmäßigerweise werden sie jedoch zum Beispiel durch aufgedampfte Aluminiumschichten mit in das Halbleiterbauelement integriert. Die Verbindung der Emitter der Fototransistoren 19 und 52 mit den Steuereingängen der FET geschieht über Leitungen 28, 44. Diese sind mit über den Steuerzonen 33, 37, 51, 53 angebrachten Polysiliciumschichten 27, 38 elektrisch verbunden. Das Substrat 20 ist dort, wo es nicht kontaktiert oder zum Lichteinfall frei liegen muß, mit einer Schutzschicht 56 bedeckt, die zum Beispiel aus Siliciumdioxid $SiO_2$ besteht. In Fig. 3 wurde diese Schicht der besseren Übersichtlichkeit halber weggelassen. Die Widerstände 11, 15 (Fig. 1) werden real durch Teile der Polysiliciumschichten 27 und 38 gebildet. Diese sind zum Beispiel über Aluminiumkontakte 40, 41, 42, 43 mit den $p^+$-leitenden Bereichen 18, 21 elektrisch ver-

0040817

bunden. In Fig. 5 ist dies symbolisch durch die Widerstände zwischen 28 und 45 beziehungsweise zwischen 44 und 46 dargestellt.

Auf den Emitter 23 des Fototransistors 19 einfallendes Licht erzeugt einen Strom. Die Polysiliciumelektrode 27 wird damit positiv vorgespannt, so daß sich in der Steuerzone 33 ein n-leitender Kanal ausbilden kann. Damit leitet der aus den Zonen 32, 33 und dem Substrat 20 bestehende FET und ein Elektronenstrom fließt in Richtung der Zone 34. Der zwischen dem Substrat 20 und der Zone 34 liegende, in Kipprichtung vorgespannte pn-Übergang wird damit auf die eingangs in Verbindung mit den Fig. 1 und 2 beschriebene Weise in Flußrichtung vorgespannt und der Teilthyristor kann zünden. Die Wirkung des aus den Zonen 32, 33 und dem Substrat 20 bestehenden FET wird durch den aus den Zonen 48, 53 und dem Substrat 20 bestehenden FET unterstützt, der dem erstgenannten parallelgeschaltet ist. Sein Strom fließt ebenfalls in Richtung der anodenseitigen Emitterzone 34.

Zweckmäßigerweise liegen die ein und demselben Teilthyristor zugeordneten Zonen und der diesem Teilthyristor zugeordnete FET wie in Fig. 3 dargestellt einander gegenüber. Lediglich die Fototransistoren liegen aus Symmetriegründen auf einander entgegengesetzten Seiten.

Die in Fig. 3, 4 und 5 gezeigten Strukturen können auf einem Substrat nach Art einer integrierten Schaltung parallelgeschaltet werden. Damit lassen sich dann Stromstärken bis zu mehreren Ampere einwandfrei schalten. Der beschriebene Triac wird durch den Fototransistor sehr schnell eingeschaltet, da der bei üblichen Triacs und Thyristoren ablaufende Zündvorgang durch die Verbindung der anodenseitigen Basiszone mit der katodenseitigen Emitterzone über einen FET stark beschleunigt wird. Die Ansteuerung des FET selbst ist leistungslos. Die einzige Verlustleistung wird in den Widerständen 11, 15 (Fig. 1) umgesetzt. Sie läßt sich jedoch durch entsprechende Dimensionierung sehr klein halten. Die Widerstände können auch ganz durch die Kondensatoren 12, 16 ersetzt werden. Im Ausführungsbeispiel werden diese durch die Zonen 29, 39 in Verbindung mit den Poly-Siliciumschichten 27, 38 gebildet. Die Zonen 29, 39 sind Bestandteile der Bereiche 18 beziehungsweise 21. Die Größe der Kondensatoren kann durch die Dicke $d_{ox}$ der über den genannten Zonen liegenden Oxidschicht 56 maßgeblich beeinflußt werden. In Fig. 5 ist dargestellt, daß die Dicke dort kleiner als über dem Substrat 20 ist.

Eine Ausführungsform kann folgende Dimensionierung der wesentlichen Teile aufweisen:

a = 100 bis 200 $\mu$m, b $\approx$ 500 $\mu$m, c = 200 $\mu$m, Dotierung des Substrats 20 bis 30 Ohm cm; Randdotierung der diffundierten $p^+$-Zonen $10^{16}$ bis $10^{17}$ cm$^{-3}$, Dicke 0,5 bis 5 $\mu$m; Dicke der implantierten $n^+$-Zonen 0,1 bis 1 $\mu$m, Implantation Dosis $10^{15}$ bis $10^{16}$ cm$^{-2}$, Energie 100 bis 150 keV; implantierte $p^+$-Zonen Dicke 0,3 bis 1 $\mu$m, Implantation Dosis 2 bis 5 . $10^{12}$ cm$^{-2}$, Energie 150 bis 200 keV; Oxiddicke $d_{ox}$ = 60 nm.

Damit konnten bei einer Lichtstärke, die von einer mit 1 mA gespeisten und 2 mm über dem Fototransistor angebrachten Infrarot-LED ausgesandt wurde, bei einer Spannung von 150 V ein Strom von 0,5 A und eine Einschaltzeit von 200 $\mu$s erzielt werden.

Der Triac wurde in Verbindung mit einem MOS-FET beschrieben. Statt der Oxidschicht 56 kann auch jede andere geeignete Isolierschicht verwendet werden. Demgemäß
soll ganz allgemein unter FET ein MIS-FET verstanden
werden.

5 Figuren
12 Patentansprüche

Patentansprüche

1. Lichtsteuerbarer Zweirichtungsthyristor mit zwei in einen Halbleiterkörper integrierten, antiparallel geschalteten Teilthyristoren, die jeweils eine katodenseitige Emitterzone, eine katodenseitige Basiszone, eine anodenseitige Emitterzone und eine anodenseitige Basiszone aufweisen, und mit einem in den Halbleiterkörper integrierten elektro-optischen Wandler, d a d u r c h g e k e n n z e i c h n e t , daß die katodenseitige Emitterzone (2, 6) oder Basiszone (3, 7) jedes Teilthyristors mit der anodenseitigen Basiszone (4) jeweils über die Laststrecke eines Feldeffekttransistors (9, 13) (FET) verbunden ist, derart, daß die Quelle des FET an der katodenseitigen Emitterzone (2, 6) oder Basiszone (3, 7) angeschlossen ist, daß für jeden FET ein opto-elektrischer Wandler (10, 14) vorgesehen ist, dessen Ausgang mit dem Steuereingang (G) des FET verbunden ist.

2. Thyristor nach Anspruch 1, d a d u r c h g e - k e n n z e i c h n e t , daß der FET (9, 13) ein MIS-FET ist.

3. Thyristor nach Anspruch 1, d a d u r c h g e - k e n n z e i c h n e t , daß der FET (9, 13) ein MOS-FET ist.

4. Thyristor nach Anspruch 1, d a d u r c h g e - k e n n z e i c h n e t , daß der opto-elektrische Wandler ein Fototransistor (10, 14) ist, daß seiner Kollektor-Emitterstrecke ein Widerstand (11, 15) in Reihe geschaltet ist, daß die Kollektor-Emitterstrecke zwischen Steuerelektrode (G) und Senke (D) und der Widerstand zwischen Steuerelektrode (G) und Quelle (S) des FET liegt.

0040817

5. Thyristor nach Anspruch 1, d a d u r c h g e - k e n n z e i c h n e t , daß der opto-elektrische Wandler ein Fototransistor (10, 14) ist, daß seiner Kollektor-Emitterstrecke ein Kondensator (12, 16) in Reihe geschaltet ist, daß die Kollektor-Emitterstrecke zwischen Steuerelektrode (G) und Senke (D) und der Kondensator zwischen Steuerelektrode (G) und Quelle (S) des FET liegt.

6. Thyristor nach Anspruch 4 und 5, d a d u r c h g e k e n n z e i c h n e t , daß dem Widerstand (11, 15) der Kondensator (12, 16) parallelgeschaltet ist.

7. Thyristor nach Anspruch 4, d a d u r c h g e - k e n n z e i c h n e t , daß die katodenseitigen Emitterzonen (31, 49) der Teilthyristoren, die Emitterzonen (23) der Fototransistoren (19, 52), die Quellen (32, 50) der FET durch Zonen des einen Leitfähigkeitstyps gebildet sind, daß die anodenseitigen Emitterzonen (34, 55) der Teilthyristoren, die katodenseitigen Basiszonen (30, 54), die Basiszonen (24) der Fototransistoren (19, 52) und die Steuerzonen (33, 51) der FET durch Zonen des anderen Leitfähigkeitstyps gebildet sind, daß die Zonen des anderen Leitfähigkeitstyps in ein Substrat (20) des einen Leitfähigkeitstyps eingebettet sind, daß die Zonen des einen Leitfähigkeitstyps in die Zonen des anderen Leitfähigkeitstyps eingebettet sind, und daß das Substrat (20) die anodenseitigen Basiszonen der Teilthyristoren, die Senken der FET und die Kollektorzonen der Fototransistoren (19, 52) bildet.

8. Thyristor nach Anspruch 7, d a d u r c h g e - k e n n z e i c h n e t , daß die Zonen (31, 32, 49, 50) des einen Leitfähigkeitstyps durch Ionenimplantation erzeugt sind und gleiche Dicke haben.

9. Thyristor nach Anspruch 7, d a d u r c h g e -
k e n n z e i c h n e t , daß die Zonen (34, 55; 33,
51; 30, 54) des anderen Leitfähigkeitstyps durch Diffusion gebildet sind und gleiche Dicke haben.

10. Thyristor nach einem der Ansprüche 1 bis 9, d a -
d u r c h g e k e n n z e i c h n e t , daß die
Steuerzonen (33, 51; 37, 53) der FET durch Ionenimplantation erzeugt und Teile der katodenseitigen Basiszonen
(30, 54) der Teilthyristoren sind.

11. Thyristor nach einem der Ansprüche 2 bis 10,
d a d u r c h g e k e n n z e i c h n e t , daß die
katodenseitige Basiszone (30, 54) des einen Teilthyristors, die Steuerzone (33, 51) des zugeordneten FET, die
anodenseitige Emitterzone (34, 55) des anderen Teilthyristors, die Basiszone (24) des dem einen Teilthyristor
zugeordneten Fototransistors (19, 52) und der mit diesem
verbundene Widerstand (11, 15 Fig. 1) je einen einzigen
zusammenhängenden, in das Substrat (20) eingebetteten
Bereich (18, 21) bilden.

12. Thyristor nach Anspruch 11, d a d u r c h g e -
k e n n z e i c h n e t , daß die Bereiche (18, 21)
auf einer Seite des Substrats (20) derart nebeneinander
angeordnet sind, daß die katodenseitige Emitterzone (31,
49) des einen Teilthyristors einem Kontakt (35, 47) für
die anodenseitige Emitterzone (34, 55) des anderen Teilthyristors gegenüberliegt, und daß der Fototransistor
(19, 52) im genannten Bereich (18, 21) neben dem Kontakt (35, 47) angeordnet ist.

FIG 1

FIG 2

FIG 3

2/2

FIG4

FIG 5

0040817

Europäisches
Patentamt

**EUROPÄISCHER RECHERCHENBERICHT**

0040817

Nummer der Anmeldung

EP 81 10 3895.9

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| P | EP - A1 - 0 021 086 (SIEMENS)<br>* Ansprüche 1, 2, 4; Fig. 1 * | 1,4,6, |
| P | & DE - A1 - 2 922 301 | 10 |
| | -- | |
| A | US - A - 3 996 475 (RODRIGUEZ)<br>* Fig. 2, 7 * | |
| | -- | |
| A | DE - A1 - 2 039 869 (ASEA)<br>* Fig. 1 * | |
| | ---- | |

**KLASSIFIKATION DER ANMELDUNG (Int. Cl.³)**

H 01 L 29/747
H 01 L 23/56
H 01 L 31/10

**RECHERCHIERTE SACHGEBIETE (Int. Cl.³)**

H 01 L 23/56
H 01 L 29/747
H 01 L 31/10

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

X Der vorliegende Recherchenbericht wurde für alle Patentansprüche erstellt.

| Recherchenort | Abschlußdatum der Recherche | Prüfer |
|---|---|---|
| Berlin | 27-08-1981 | ROTHER |

EPA form 1503.1 06.78